# EUROPEAN PATENT APPLICATION

(11) **EP 4 621 925 A1**
(43) Date of publication of application: **24.09.2025**
(21) Application number: 25162011.8
(22) Date of filing: 06.03.2025
(51) Int. Cl.: H01M 10/42, H01M 50/284, H01M 50/507, H01M 50/519, H01M 50/569

(54) **BATTERY PACK**

(30) Priority: 22.03.2024 KR 20240039800
(71) Applicant: SAMSUNG SDI CO., LTD., Yongin-si, Gyeonggi-do 17084 (KR)
(72) Inventor: PARK, KYUNGHOON, 17084 Yongin-si, Gyeonggi-do (KR)
(74) Representative: Gulde & Partner

(57) **Abstract**

A battery pack includes a battery module including battery cells and a bus bar configured to electrically connect the battery cells, and a circuit board connected to the battery module that includes a first portion extending in a longitudinal direction of the battery module, second portions extending from the first portion in a direction crossing the first portion that each include a circuit pattern, and a third portion connected to an end of each of the second portions and connected to the bus bar. Each second portion extends straight without being bent or folded.

## Description

### BACKGROUND

### 1. Field

One or more embodiments relate to a battery pack.

### 2. Description of the Related Art

Secondary batteries are batteries designed to be charged and discharged and may be used as energy sources for mobile devices, electric vehicles, hybrid vehicles, electric bicycles, uninterruptible power supplies, etc. A single secondary batteries or multi-secondary battery (secondary battery modules) in which a plurality of battery cells are connected as one unit are utilized depending on the types of external devices that employ the secondary batteries.

The above information disclosed in this Background section is only for enhancement of understanding of the background of the disclosure, and therefore, it may contain information that does not constitute the related art.

### SUMMARY

The present invention is set out in the appended set of claims, wherein the drawings and respective description relate to advantageous embodiments thereof.

It was an object of the present invention to provide a battery pack in which damage such as disconnection of a circuit board may be prevented by improving the durability of the circuit board.

However, the technical problems to be solved by embodiments are not limited to the above, and other problems not mentioned herein will be clearly understood by one of ordinary skill in the art from the following description.

Additional aspects will be set forth in part in the description which follows and, in part, will be apparent from the description, or may be learned by practice of the presented embodiments.

According to the invention, a battery pack includes a battery module including battery cells and a bus bar configured to electrically connect the battery cells, and a circuit board connected to the battery module that includes a first portion extending in a longitudinal direction of the battery module, second portions extending from the first portion in a direction crossing the first portion that each include a circuit pattern, and a third portion connected to an end of each of the second portions and connected to the bus bar. Each second portion extends straight without being bent or folded.

Each second portion may extend at an obtuse angle with respect to the longitudinal direction of the first portion.

Each second portion may include a base, and the circuit pattern may be on the base.

A first end of the circuit pattern may be connected to the first portion and a second end of the circuit pattern may be connected to the third portion, and the circuit pattern may include one or more convex portions and/or one or more concave portions between the first end and the second end.

The circuit pattern may include circuit patterns having a wave shape, and a thickness of each of the circuit patterns may be less than an interval between the circuit patterns.

The circuit pattern may include a first pattern at a center in a width direction of the base, and a second pattern adjacent to the first pattern and spaced apart from the first pattern.

The circuit pattern may further include a third pattern on the base that is spaced apart from the first pattern and the second pattern and the third pattern and the second pattern may be on opposite sides of the first pattern.

Each second portion may further include a dummy pattern on the base, spaced apart from the circuit pattern, and having a shape corresponding to the curved portion of the circuit pattern.

The dummy pattern may include dummy pattern portions on both sides in a width direction of the base and the circuit pattern may be between the dummy pattern portions.

The first portion may include a first connection area connected to the circuit pattern, and each second portion may include a second connection area connected to the circuit pattern and the third portion.

### BRIEF DESCRIPTION OF THE DRAWINGS

The above and other aspects, features, and advantages of certain embodiments of the present disclosure will be more apparent from the following description taken in conjunction with the accompanying drawings.

The accompanying drawings illustrate preferred embodiments of the present disclosure and, together with the foregoing disclosure, serve to provide further understanding of the technical spirit of the present disclosure. However, the disclosure is not to be construed as being limited to the drawings, in which:
FIG. 1 illustrates a vehicle including a battery pack;
FIG. 2 is an exploded perspective view illustrating the battery pack;
FIG. 3 is an assembled perspective view illustrating the battery pack;
FIG. 4 is an enlarged view illustrating a part of the battery pack;
FIG. 5 illustrates a circuit board;
FIG. 6 is an enlarged view illustrating a conventional circuit board and demonstrates an embodiment of the prior art;
FIG. 7 is an enlarged view illustrating the circuit board;
FIGS. 8A, 8B, and 8C illustrate various embodiments of the circuit board;
FIGS. 9A, 9B, and 9C illustrate various embodiments of the circuit board; and
FIGS. 10A and 10B illustrate a bending test on the circuit board.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments may be combined or combined with each other, in part or in whole, and technically various interlocking and driving are possible. Each embodiment may be implemented independently of each other or may be implemented together in an association. The described embodiments are provided as examples so that this disclosure will be thorough and complete, and will fully convey the aspects of the disclosure to those skilled in the art. It should be understood that the disclosure covers all the modifications, equivalents, and replacements within the idea and technical scope of the disclosure. Accordingly, processes, elements, and techniques that are not necessary to those having ordinary skill in the art for a complete understanding of the aspects of the disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the disclosure. Thus, embodiments disclosed herein should not be construed as limited to the illustrated shapes of regions, but are to include deviations in shapes that result from, for instance, manufacturing.

The regions illustrated in the drawings are schematic in nature and their shapes are not intended to illustrate the actual shape of a region of a device and are not intended to be limiting.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" may encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it may be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it may be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it may be the only element or layer between the two elements or layers, or one or more intervening elements or layers may also be present.

For the purposes of this disclosure, expressions such as "at least one of," or "any one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terms used in the present application are merely used to describe specific embodiments, and are not intended to limit the disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components. However, these terms do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

Unless otherwise defined, all terms (including technical and scientific terms) used herein have the same meaning as commonly understood by one of ordinary skill in the art to which the disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

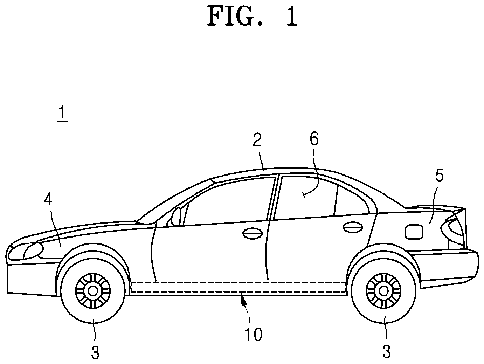

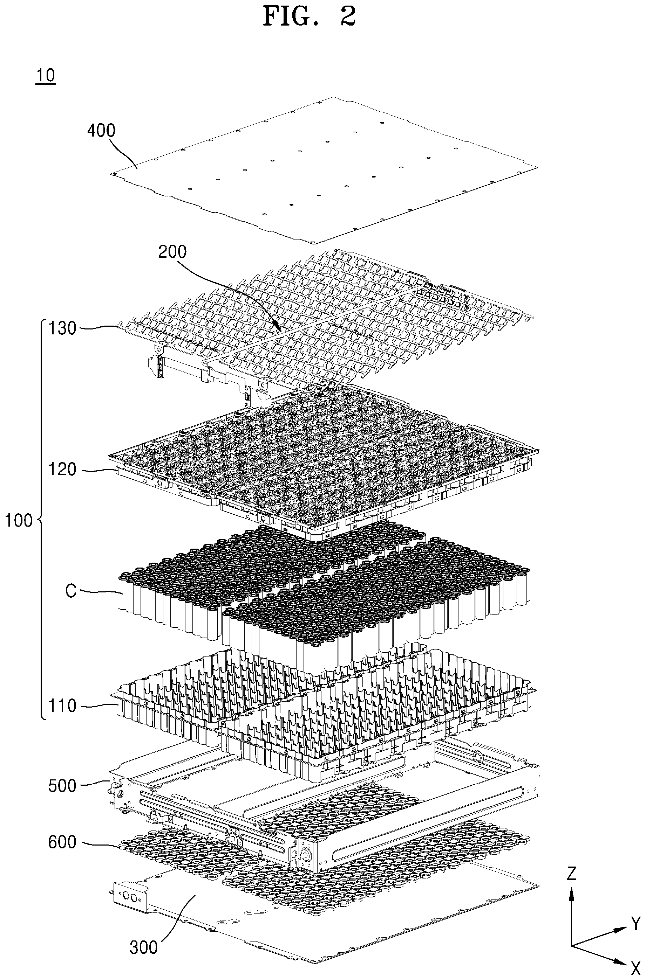

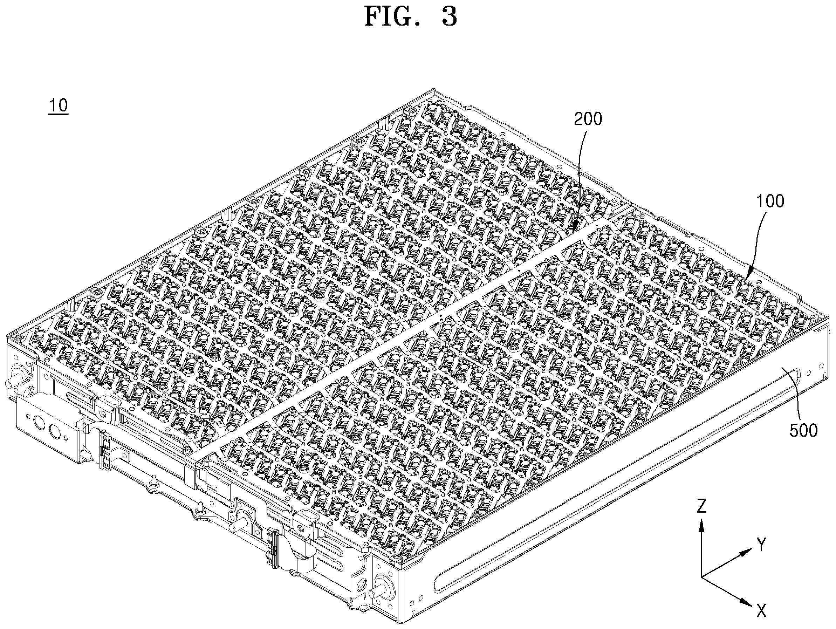

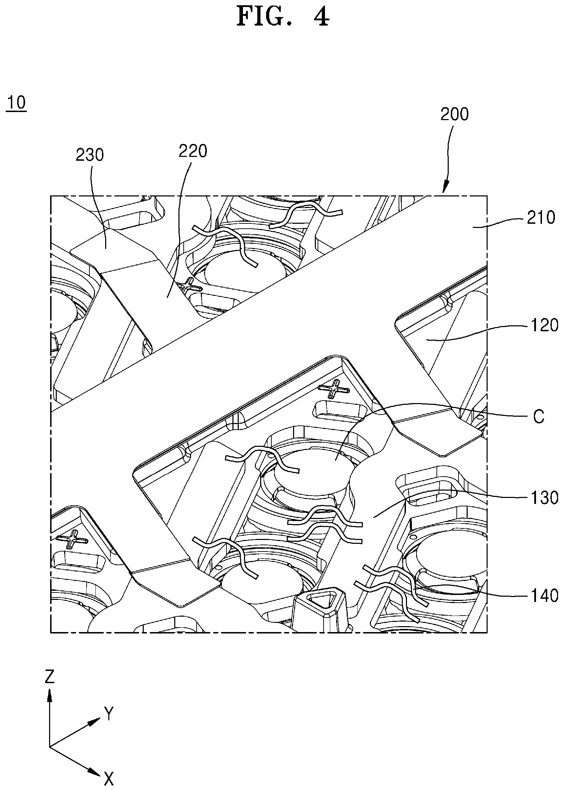

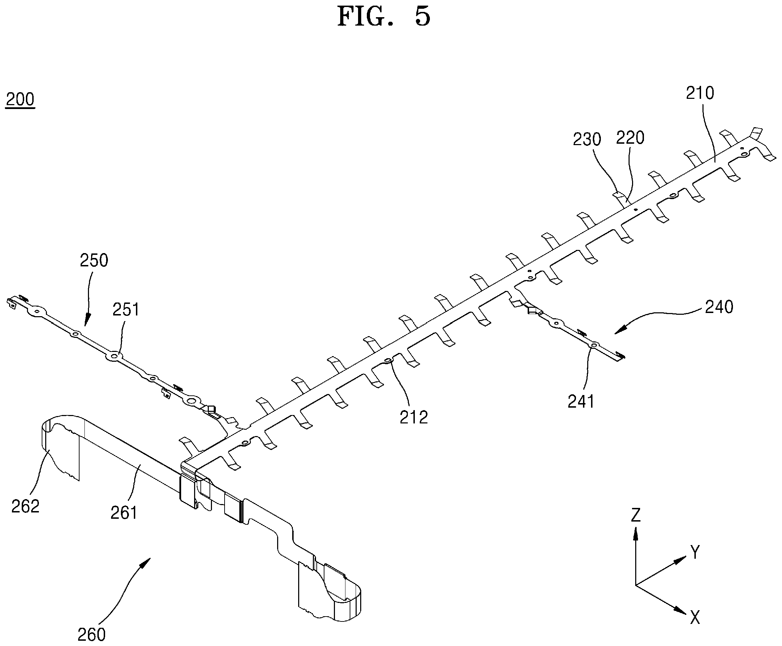

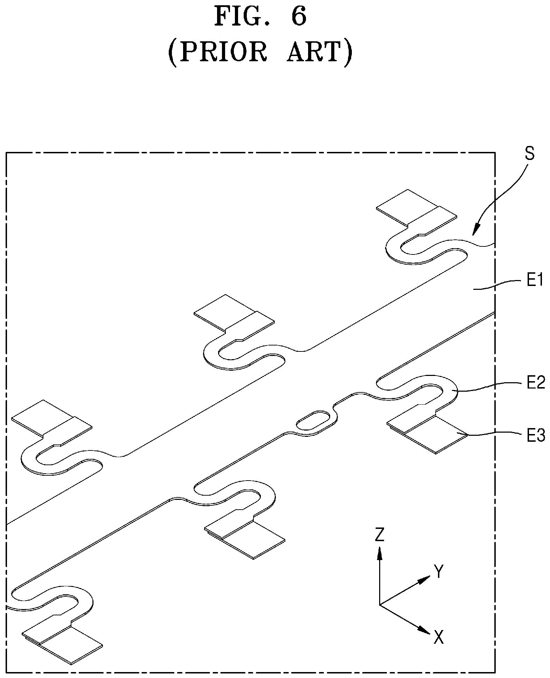

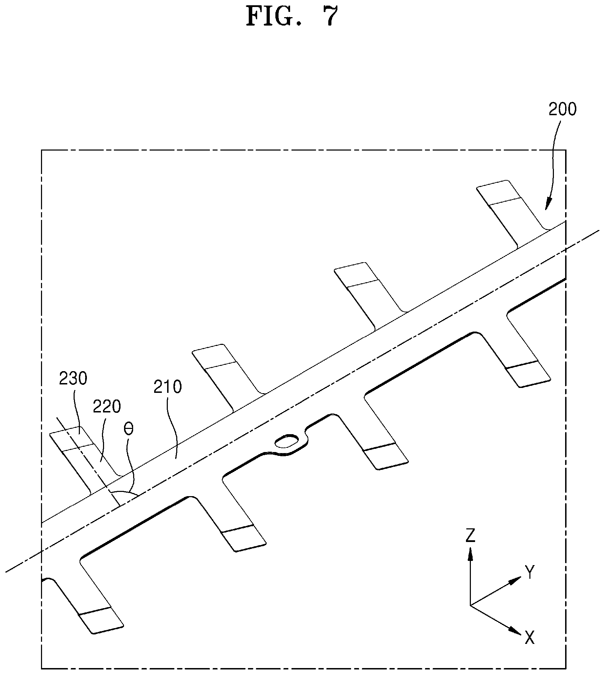

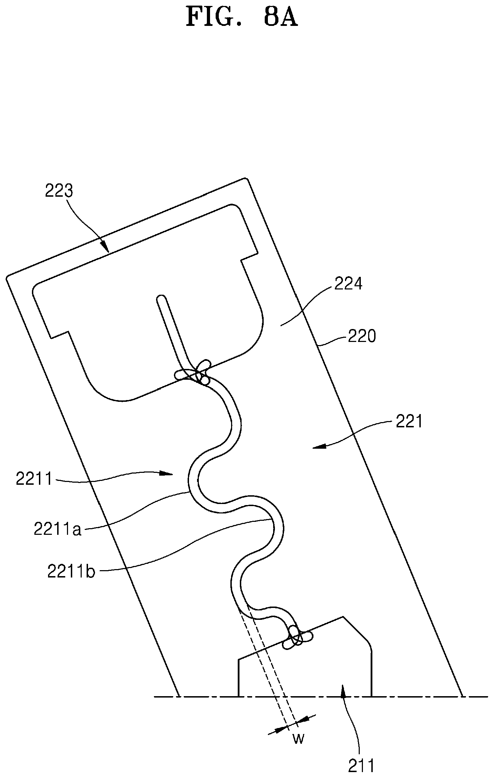

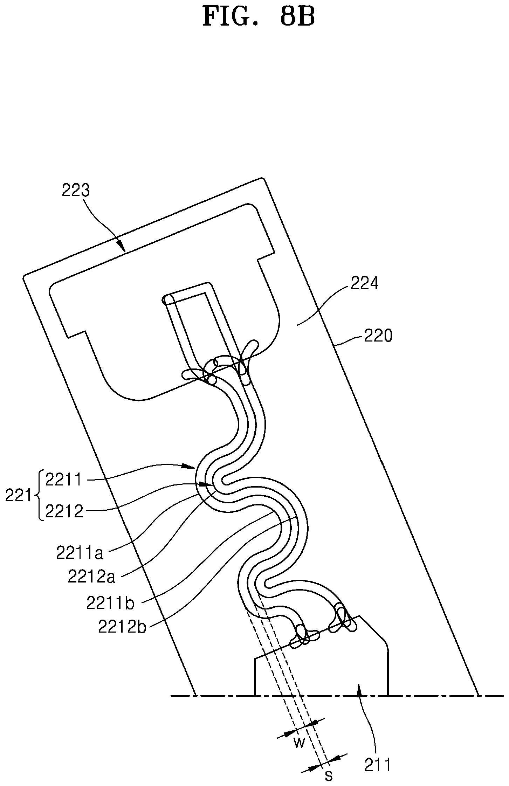

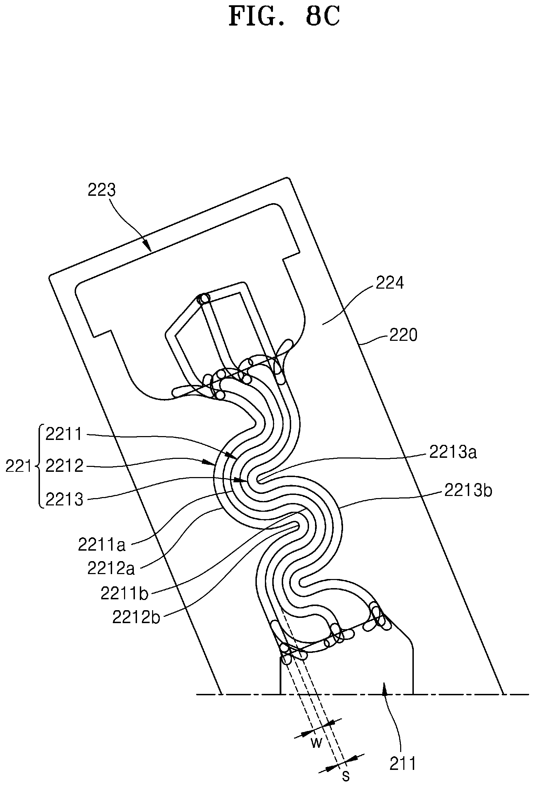

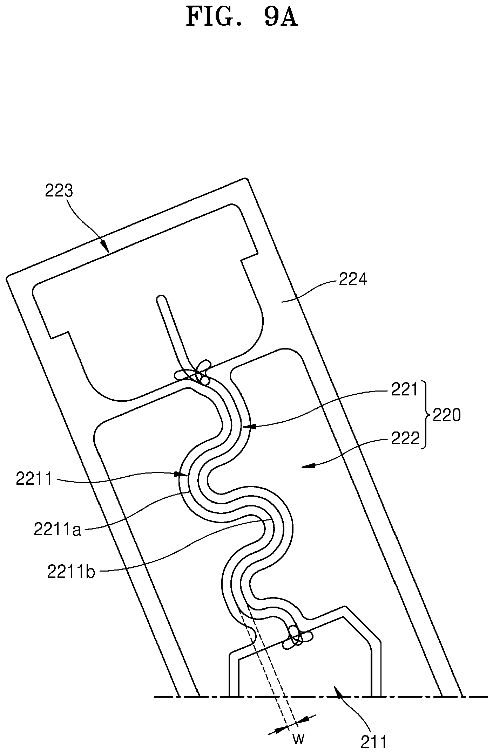

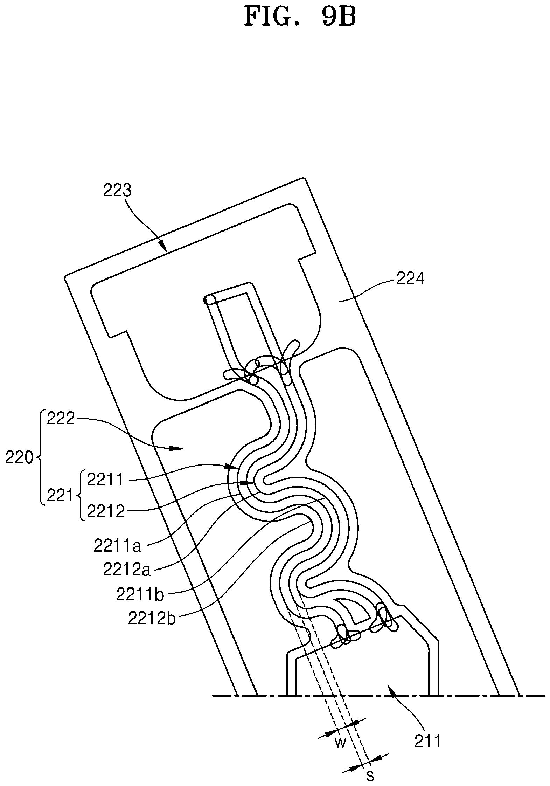

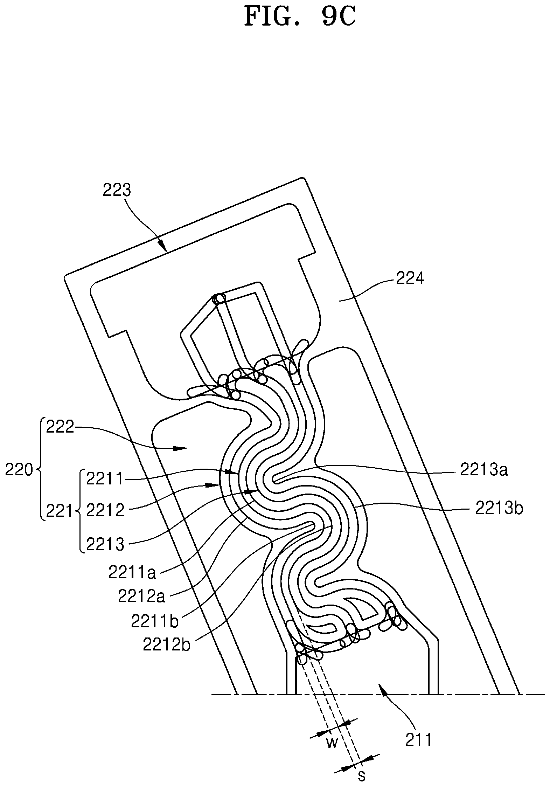

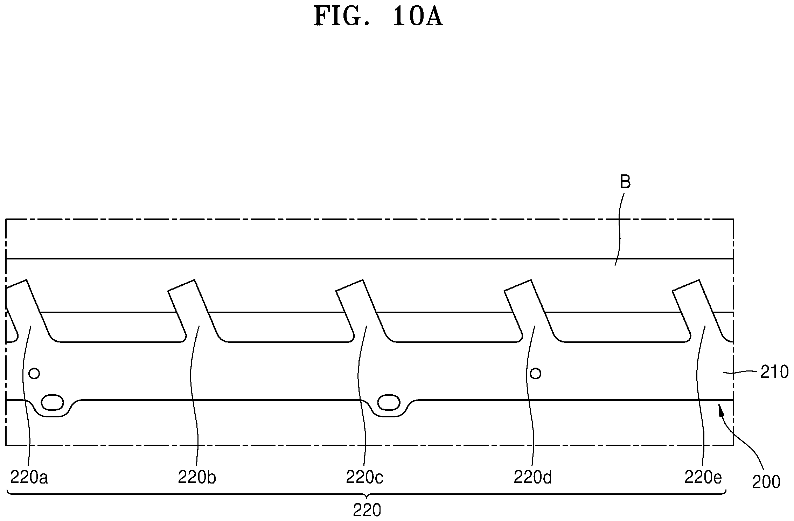

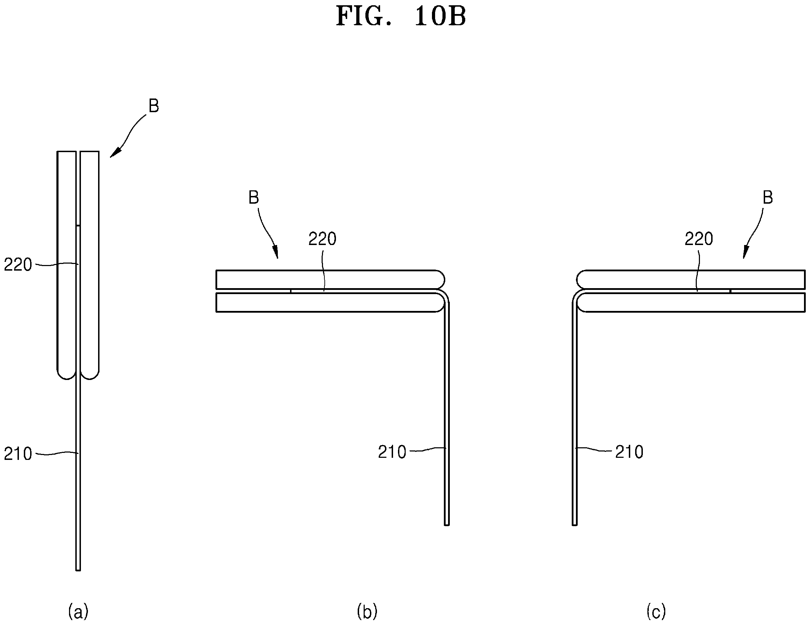

FIG. 1 illustrates a vehicle 1 including a battery pack 10. FIG. 2 is an exploded perspective view illustrating the battery pack 10 according to one embodiment. FIG. 3 is an assembled perspective view illustrating the battery pack 10. FIG. 4 is an enlarged view illustrating a part of the battery pack 10. FIG. 5 illustrates a circuit board 200. FIG. 6 is an enlarged view illustrating a conventional circuit board S demonstrating an embodiment of the prior art. FIG. 7 is an enlarged view illustrating the circuit board 200. FIGS. 8A, 8B, and 8C illustrate various embodiments of the circuit board 200. FIGS. 9A, 9B, and 9C illustrate various embodiments of the circuit board 200. FIGS. 10A and 10B illustrate a bending test on the circuit board 200.

The battery pack 10 may include one or more battery modules 100 and may be utilized in various applications. In one or more embodiments, the battery pack 10 may be utilized in large applications, such as an energy storage system (ESS), or small and medium-sized applications, such as various electronic devices including an electric tool. In one or more embodiments, the battery pack 10 may be included in the vehicle 1 as shown in FIG. 1. The vehicle 1 may be an electric vehicle, a hybrid vehicle, or a plug-in hybrid vehicle. The vehicle 1 may be a four-wheeled vehicle or a two-wheeled vehicle. The battery pack 10 may be in a frame 2 of the vehicle 1. In one or more embodiments, as shown in FIG. 1, the battery pack 10 may be between a front portion 4 and a rear portion 5 of the vehicle 1, between two wheels 3, and below an inner space 6 in which a user is present (e.g., the cabin).

The battery pack 10 may include the battery module 100 and the circuit board 200.

One or more battery modules 100 may be included in the battery pack 10. In one or more embodiments, as shown in FIG. 2, two battery modules 100 may be included in the battery pack 10. However, the number of battery modules 100 included in the battery pack 10 is not limited to two, and may be one, or three or more. The battery module 100 may be in a frame 500 of the battery pack 10 and may be between a lower plate 300 and an upper plate 400. A plurality of battery modules 100 may be spaced apart from each other and may be electrically connected to each other through the circuit board 200. One or more battery modules 100 may include a plurality of battery cells C. Each of the battery cells C may have a cylindrical shape, a prismatic shape, or a pouch shape. For convenience of explanation, the following will be described assuming that the battery cell C has a cylindrical shape.

The battery module 100 may include a lower holder 110, an upper holder 120, a bus bar 130, and a tab 140.

Together, the lower holder 110 and the upper holder 120 accommodate the plurality of battery cells C. The lower holder 110 may be on a lower portion of the battery module 100 and may form a space in which the plurality of battery cells C are accommodated with the upper holder 120. The lower holder 110 may include a plurality of openings in which the plurality of battery cells C are accommodated. A bottom surface of the lower holder 110 may contact a heat dissipating member 600, and the lower holder 110 may be in the frame 500.

The upper holder 120 may be on an upper portion of the battery module 100 and may form a space in which the plurality of battery cells C are accommodated with the lower holder 110. The upper holder 120 may include a plurality of openings in which the plurality of battery cells C are accommodated. Each opening of the upper holder 120 may correspond to each opening of the lower holder 110. In a state where the plurality of battery cells C are inserted into the upper holder 120, an upper end of each battery cell C may be exposed to the outside through one of the openings of the upper holder 120 and may be connected to the bus bar 130 through the tab 140. The bus bar 130 may be on (e.g., above or over) the upper holder 120, and each tab 140 may connect one of the battery cells C to the bus bar 130. The number of lower holders 110 and upper holders 1210 may be the same as the number of battery modules 100.

The bus bar 130 may be connected to the plurality of battery cells C. In one or more embodiments, as shown in FIGS. 2 and 4, the bus bar 130 may be on (e.g., above or over) the upper holder 120 and may be electrically connected to the plurality of battery cells C through a plurality of tabs 140. The bus bar 130 may extend between the plurality of battery cells C and the upper portions of the plurality of battery cells C may be exposed through the openings of the upper holder 120. The bus bar 130 may include a conductive material such as a metal. One bus bar 130 may be included in one battery module 100.

The bus bars 130 may extend in different directions and may be respectively connected to the plurality of battery cells C. In one or more embodiments, the bus bar 130 may extend in a longitudinal direction (e.g., a Y-axis direction of FIG. 2) of the battery pack 10 and a width direction (e.g., an X-axis direction of FIG. 2) of the battery pack 10 and may be between the battery cells C.

For each of the battery cells C, the tab 140 may electrically connect the battery cell C to the bus bar 130. In one or more embodiments, as shown in FIG. 4, a first end of the tab 140 may be connected to the bus bar 130 and a second end of the tab 140 may be connected to the battery cell C. The tab 140 may include a conductive material such as a metal, and may have a wire shape with one or more bent sections. In one or more embodiments, a plurality of tabs 140 may be provided. One battery cell C may be connected to one or more tabs 140. In one or more embodiments, as shown in FIG. 4, two tabs 140 may be connected to one battery cell C. A first end of a first tab 140 may be connected to a top surface of the battery cell C and a second end of the first tab 140 may be connected to a top surface of the bus bar 130. A first end of a second tab 140 may be connected to an upper edge of the battery cell C and a second end of the second tab 140 may be connected to the top surface of the bus bar 130.

The circuit board 200 may be connected to the bus bar 130 and may be configured to detect a state of each battery module 100 and to control the battery module 100. In one or more embodiments, the circuit board 200 may be connected to a controller or a battery monitoring system (BMS) and may be configured to measure a voltage and a temperature of each battery cell C included in the battery module 100 and to transmit the voltage and the temperature to the BMS. The BMS may control the battery module 100 through the circuit board 200. In one or more embodiments, the circuit board 200 may be a flexible printed circuit board assembly (FPCA) and may include a flexible circuit board (FPCB) and components mounted on the FPCB.

The circuit board 200 may be between the battery module 100 and the upper plate 400. In one or more embodiments, as shown in FIGS. 2 and 3, the circuit board 200 may be on (e.g., above or over) the battery module 100. A part of the circuit board 200 (e.g., a first portion 210 of the circuit board 200) may be between two adjacent battery modules 100, and other parts of the circuit board 200 (e.g., a second portion 220 and a third portion 230 of the circuit board 200) may be over the battery module 100 and may be connected to the plurality of battery cells C, as shown in FIG. 4. One or more circuit boards 200 may be included in the battery pack 10.

The circuit board 200 may include the first portion 210, the second portion 220, and the third portion 230.

The first portion 210 may connect other portions of the circuit board (e.g., the second portion 220 and the third portion 230) to the controller and/or the BMS. In one or more embodiments, the first portion 210 may extend in one direction (e.g., the longitudinal direction of the battery pack 10 or the Y-axis direction of FIG. 2). The first portion 210 may be on (e.g., above or over) the battery module 100, for example, between two adjacent battery modules 100. The first portion 210 may be supported on the upper holder 120, and a plurality of second portions 220 and third portions 230 may extend from the first portion 210 and may be connected to the bus bar 130. In one or more embodiments as shown in FIG. 5, the first portion 210 may have a rod shape extending lengthwise in one direction, and the plurality of second portions 220 and third portions 230 may extend laterally (e.g., in the X-axis direction) from both side surfaces (e.g., opposite side edges) of the first portion 210 (e.g., both side surfaces in the X-axis direction of FIG. 5). The plurality of second portions 220 and third portions 230 may be formed in a zigzag shape so that the plurality of second portions 220 and third portions 230 formed on a first side of the first portion 210 and the plurality of second portions 220 and third portions 230 formed on a second side of the first portion 210 do not overlap each other (e.g., the plurality of second portions 220 and the plurality of third portions 230 may be staggered along the first portion 210 in the Y-axis direction).

In one or more embodiments, as shown in FIG. 8A, the first portion 210 may include a plurality of wirings connected to a circuit pattern 221 of the second portion 220. The plurality of wirings may be arranged on a top surface of the first portion 210 and may be connected to the circuit patterns 221 of the plurality of second portions 220.

The first portion 210 may include a first fixing hole 212. In one or more embodiments, as shown in FIG. 5, one or more first fixing holes 212 may be on a first side and/or a second side of the first portion 210 and may be between two adjacent second portions 220 in a longitudinal direction of the circuit board 200. The first fixing hole 212 may be used to fix or connect the circuit board 200 to the battery module 100. In one or more embodiments, a protrusion on the upper holder 120 may be inserted into the first fixing hole 212.

One or more second portions 220 may extend from the first portion 210. In one or more embodiments, as shown in FIGS. 4 and 5, the plurality of second portions 220 may extend toward the bus bar 130 in a direction (e.g., the X-axis direction) crossing a direction (e.g., the Y-axis direction) in which the first portion 210 extends. The third portion 230 may be connected to an end of the second portion 220 and the third portion 230 may be connected to the bus bar 130 so that the bus bar 130 and the circuit board 200 are connected to each other. In one or more embodiments, as shown in FIG. 7, the second portion 220 may extend at an interior angle θ with respect to a longitudinal direction (e.g., the Y-axis direction of FIG. 7) of the first portion 210. Each second portion 220 of the plurality of second portions 220 may extend obliquely with respect to the longitudinal direction of the first portion 210. The angle θ may be an oblique angle (e.g., an acute angle). Because the second portion 220 extends obliquely with respect to the first portion 210, a length of the second portion 220 in the width direction (e.g., the X-axis direction of FIG. 7) of the battery pack 10 may be reduced and a sufficient length for the second portion 220 to be connected to the bus bar 130 may be achieved. The angle θ may be 30° to 80°. The angle θ may be 40° to 70°, the angle θ may be 30°, 40°, 50°, 60° or 70° or any range within that values.

The first portion 210 may extend straight in one direction, and the second portion 220 may also extend straight from both side surfaces of the first portion 210 without being folded or bent (e.g., the second portions 220 are straight rather than curved). In one or more embodiments, the first portion 210 may have a rod shape extending straight in a direction parallel to the longitudinal direction of the battery pack 10. The second portion 220 may be inclined at the angle θ with respect to the longitudinal direction of the first portion 210 on both side surfaces of the first portion 210 and may extend straight without being folded or bent. Accordingly, damage to the circuit board 200 due to vibration may be prevented (or at least mitigated), compared to the conventional circuit board S. As shown in FIG. 6, in the related art circuit board S, a second portion E2 curves from both side surfaces of a first portion E1, and a third portion E3 is connected to an end of the second portion E2. Accordingly, the overall length of the second portion E2 excessively increases, thereby reducing the durability of the second portion E2. Also, because the second portion E2 is excessively curved to have U-shape, a circuit pattern included in the second portion E2 is also excessively curved to correspond to the shape of the second portion E2. Accordingly, the circuit pattern may be easily broken due to vibration or may deviate from a designated position.

According to one or more embodiments of the present disclosure, because the second portion 220 extends straight, the length of second portion 220 may be reduced, thereby increasing the durability of a connection between the second portion 220 and the first portion 210 and increasing the durability of the second portion 220 itself. Also, because the circuit pattern 221 includes a curved portion but its width is limited to a width of the second portion 220, the circuit pattern 221 may not be easily damaged by vibration.

The second portion 220 may include the circuit pattern 221.

One or more circuit patterns 221 may be on the second portion 220 and may electrically connect the bus bar 130 to the circuit board 200 by connecting the first portion 210 to the third portion 230. In one or more embodiments, one or more circuit patterns 221 may be arranged at the center in a width direction of the second portion 220. The circuit pattern 221 may include a metal such as copper, silver, or aluminum or other conductive materials. The circuit pattern 221 may include one or more curved portions and may have, for example, a wave shape (e.g., a serpentine or sinusoidal shape). A first end of the circuit pattern 221 may be connected to a first connection area 211 that connects the first portion 210 to the second portion 220, and a second end of the circuit pattern 221 may be connected to a second connection area 223 that connects the second portion 220 to the third portion 230. The overall width of the circuit pattern 221 (e.g., the width in the width direction of the second portion 220) may be less than the width of the second portion 220.

The circuit pattern 221 may include a first pattern 2211. In one or more embodiments, as shown in FIG. 8A, a first end of the first pattern 2211 may be connected to the first connection area 211, and a second end of the first pattern 2211 may be connected to the second connection area 223. The first pattern 2211 may be at the center in the width direction of the second portion 220 and may include one or more curved portions. In one or more embodiments, the first pattern 2211 may include one or more convex portions 2211a and one or more concave portions 2211b, and may have a wave shape (e.g., the first pattern 2211 may include alternating convex portions 2211a and concave portions 2211b). As shown in FIG. 8A, the first pattern 2211 may have an S shape in which one or more convex portions 2211a and one or more concave portions 2211b are alternately repeated.

The circuit pattern 221 may have a width (thickness) w. The width w may refer to a thickness of a wire forming the circuit pattern 221. The width w may be from 0.2 mm to 0.5 mm. In one or more embodiments, the width w may be from 0.25 mm to 0.4 mm, or 0.3 mm to 0.45 mm.

The circuit pattern 221 may include a plurality of circuit patterns 221. In one or more embodiments, as shown in FIG. 8B, the circuit pattern 221 may include a first pattern 2211 and a second pattern 2212. The second pattern 2212 may be adjacent to the first pattern 2211, and like the first pattern 2211, a first end of the second pattern 2212 may be connected to the first connection area 211 and a second end of the second pattern 2212 may be connected to the second connection area 223. The second pattern 2212 may include one or more curved portions, for example, one or more convex portions 2212a and one or more concave portions 2212b, and may have a wave shape (e.g., a serpentine or sinusoidal shape). As shown in FIG. 8B, the second pattern 2212 may have an S shape in which one or more convex portions 2212a and one or more concave portions 2212b are alternately repeated.

The second pattern 2212 may be adjacent to the first pattern 2211 but may be spaced apart from the first pattern 2211 so as not to overlap the first pattern 2211. In one or more embodiments, the second pattern 2212 may have the same length and shape as the first pattern 2211. Also, the convex portion 2211a and the concave portion 2211b of the first pattern 2211 and the convex portion 2212a and the concave portion 2212b of the second pattern 2212 may correspond to each other.

The first pattern 2211 and the second pattern 2212 may be spaced apart from each other by an interval s (e.g., a gap). In one or more embodiments, the interval s may refer to a minimum separation distance between the first pattern 2211 and the second pattern 2212. The interval s may be from 0.1 mm to 0.5 mm. In one or more embodiments, the interval s may be from 0.15 mm to 0.45 mm. In one or more embodiments, the interval s may be from 0.2 mm to 0.35 mm. The thicknesses (widths) w of the first pattern 2211 and the second pattern 2212 may be the same, and the thickness w may be less than the interval s (e.g., the interval s may be larger than the thickness w of each of the first pattern 2211 and the second pattern 2212).

In one or more embodiments, as shown in FIG. 8C, the circuit pattern 221 may include the first pattern 2211, the second pattern 2212, and a third pattern 2213.

The third pattern 2213 may be adjacent to the first pattern 2211, and like the first pattern 2211, a first end of the third pattern 2213 may be connected to the first connection area 211 and a second end of the third pattern 2213 may be connected to the second connection area 223. The third pattern 2213 may include one or more curved portions, for example, one or more convex portions 2213a and one or more concave portions 2213b, and may have a wave shape (e.g., a serpentine or sinusoidal shape). As shown in FIG. 8C, the third pattern 2213 may have an S shape in which one or more convex portions 2213a and one or more concave portions 2213b are alternately repeated.

The third pattern 2213 may be adjacent to the first pattern 2211, but may be spaced apart from the first pattern 2211 so as not to overlap the first pattern 2211. In one or more embodiments, as shown in FIG. 8C, the third pattern 2213 and the second pattern 2212 may be on opposite sides of the first pattern 2211, with the second pattern 2212 being on a left side of the first pattern 2211 and the third pattern 2213 being on a right side of the first pattern 2211, for example. The third pattern 2213 may be spaced apart from the first pattern 2211 by the interval s. In one or more embodiments, the third pattern 2213 may have the same length and shape as the first pattern 2211. Also, the convex portion 2211a and the concave portion 2211b of the first pattern 2211, the convex portion 2212a and the concave portion 2212b of the second pattern 2212, and the convex portion 2213a and the concave portion 2213b of the third pattern 2213 may correspond to each other. The thicknesses (widths) w of the first pattern 2211, the second pattern 2212, and the third pattern 2213 may be the same, and the thickness w may be less than the interval s between the first pattern 2211, the second pattern 2212, and the third pattern 2213.

In one or more embodiments, the circuit pattern 221 may include the first pattern 2211, the second pattern 2212, and the third pattern 2213, the thicknesses w of the first pattern 2211, the second pattern 2212, and the third pattern 2213 may be from 0.25 mm to 0.3 mm, and the interval s between the first pattern 2111 and the second pattern 2212, and between the third pattern 2213 and the first pattern 2111 may be 0.2 mm. Also, the second portion 220 may include a dummy pattern 222. In one or more embodiments, the circuit pattern 221 may include the first pattern 2211, the second pattern 2212, and the third pattern 2213, the thicknesses w of the first pattern 2211, the second pattern 2212, and the third pattern 2213 may be 0.25 mm, and the interval s between the first pattern 2211 and the second pattern 2212, and between the third pattern 2213 and the first pattern 2211 may be 0.4 mm. Also, the second portion 220 may include the dummy pattern 222.

The second portion 220 may include the dummy pattern 222. The dummy pattern 222 does not allow current to flow, and is on the second portion 220 and adjacent to the circuit pattern 221 to increase the rigidity of the second portion 220, thereby preventing (or at least mitigating) damage to the second portion 220. In one or more embodiments, as shown in FIGS. 9A, 9B, and 9C, the dummy patterns 222 may be on both sides in the width direction of the second portion 220. The dummy pattern 222 may be spaced apart from each of the circuit pattern 221, the first connection area 211, and the second connection area 223. One pair of dummy patterns 222 may be spaced apart from each other, and the circuit pattern 221 may be between the pair of dummy patterns 222. The dummy pattern 222 may include a conductive material such as copper and/or a non-conductive material.

The dummy pattern 222 may have a size and a shape corresponding to the circuit pattern 221. In one or more embodiments, as shown in FIG. 9A, the one pair of dummy patterns 222 may be spaced apart from each other with the first pattern 2211 therebetween. Also, the pair of dummy patterns 222 may have a curved shape corresponding to the convex portion(s) 2211a and the concave portion(s) 2211b of the first pattern 2211. Also, as shown in FIG. 9B, the pair of dummy patterns 222 may be spaced apart from each other with the first pattern 2211 and the second pattern 2212 therebetween. Also, the pair of dummy patterns 222 may have a curved shape to correspond to the convex portion(s) 2211a and the concave portion(s) 2211b of the first pattern 2211 and the convex portion(s) 2212a and the concave portion(s) 2212b of the second pattern 2212. Also, as shown in FIG. 9C, the pair of dummy patterns 222 may be spaced apart from each other with the first pattern 2211, the second pattern 2212, and the third pattern 2213 therebetween. Also, the pair of dummy patterns 222 may have a curved shape to correspond to the convex portion(s) 2211a and the concave portion(s) 2211b of the first pattern 2211, the convex portion(s) 2212a and the concave portion(s) 2212b of the second pattern 2212, and the convex portion(s) 2213a and the concave portion(s) 2213b of the third pattern 2213.

The second portion 220 may include a base 224. In one or more embodiments, the base 224 may have a flat plate shape with a length less than that of the first portion 210 and may extend in a direction crossing the first portion 210. In one or more embodiments, the base 224 may extend straight without being bent or folded, and may be inclined by the angle θ with respect to the first portion 210. The circuit pattern 221, the dummy pattern 222, and the second connection area 223 may be on the base 224.

The third portion 230 may connect the circuit pattern 221 to the bus bar 130. In one or more embodiments, at least a portion of the third portion 230 may be connected to the second portion 220 (e.g., the second connection area 223). The third portion 230 may contact the bus bar 130. The third portion 230 may be configured to detect a state such as a temperature and a voltage of the battery cells C through the bus bar 130, and the detected state information may be transmitted to the BMS through the second portion 220 and the first portion 210 through the circuit pattern 221.

The circuit board 200 may include a first extending portion 240, a second extending portion 250, and a support 260.

As shown in FIG. 5, the first extending portion 240 may extend from a first side of the first portion 210, and the second extending portion 250 may extend from a second side of the first portion 210 (e.g., the first extending portion 240 and the second extending portion 250 may extend in opposite directions from opposite sides of the first portion 210). The first extending portion 240 and the second extending portion 250 may be located at different positions along the length of the first portion 210 and may extend in different directions. The first extending portion 240 and the second extending portion 250 may respectively include a second fixing hole 241 and a third fixing hole 251, and protrusions on the upper holder 120 may be inserted into the second fixing hole 241 and the third fixing hole 251 so that the circuit board 200 and the battery module 100 are firmly connected to each other.

The support 260 may be at an end of the first portion 210 and may be connected to the frame 500. In one or more embodiments, as shown in FIG. 5, the support 260 may include a first support 261 extending from the end of the first portion 210 to both sides (e.g., in opposite lateral directions) and a second support 262 bent and extending from an end of the first support 261. The first support 261 and the second support 262 may be connected to the frame 500 in a state in which the battery pack 10 is assembled so that the circuit board 200 is supported on the frame 500.

The battery pack 10 may further include the lower plate 300, the upper plate 400, the frame 500, and the heat dissipating member 600.

The lower plate 300 may be on a lower portion of the battery pack 10 and may support the frame 500. In one or more embodiments, the lower plate 300 may have a size corresponding to one or more battery modules 100 and may have a flat shape. The lower plate 300 may be under the battery module 100, and an edge or edges of the lower plate 300 may be connected to the frame 500. In one or more embodiments, the lower plate 300 may be a cooling plate configured to cool the battery pack 10. The lower plate 300 may include a material having high thermal conductivity (e.g., aluminum or copper) and may be configured to release heat generated in the battery module 100 to the outside. In one or more embodiments, the lower plate 300 may include a flow path through which a cooling fluid (e.g., cooling water, air, etc.) flows. The heat dissipating member 600 may be on the lower plate 300.

The upper plate 400 may be on an upper portion of the battery pack 10 and may support the frame 500. In one or more embodiments, the upper plate 400 may have a size corresponding to one or more battery modules 100 and may have a flat shape. The upper plate 400 may be on (e.g., above or over) the battery module 100, and an edge or edges of the upper plate 400 may be connected to the frame 500. The upper plate 400 may be on (e.g., above or over) the bus bar 130 of the battery module 100 and the circuit board 200. In one or more embodiments, the upper plate 400 may be a fire prevention plate configured to prevent flame propagation of the battery pack 10. In one or more embodiments, the upper plate 400 may include MICA. The upper plate 400 may be configured to cause a flame generated in any one battery cell C to remain inside the lower holder 110 and the upper holder 120 without propagating to the outside of the battery module 100.

A fire extinguishing agent may be included in the upper plate 400. In response to a fire occurring in one or more of the battery cells C and thus, the internal pressure of the battery module 100 increasing due to gas released from the battery cell C, a part of the upper plate 400 may rupture, and the fire extinguishing agent in the upper plate 400 may be ejected to the battery module 100.

The frame 500 may hold and support other components of the battery pack 10 (e.g., the battery module 100, the circuit board 200, the lower plate 300, the upper plate 400, and the heat dissipating member 600). In one or more embodiments, as shown in FIG. 2, the frame 500 may be a quadrangular frame having an inner space configured to accommodate the battery module 100. The frame 500 may support other components of the battery pack 10 and may be configured to allow the battery pack 10 to be mounted or installed in other applications such as the vehicle 1.

The heat dissipating member 600 may be between the battery module 100 and the lower plate 300 and may be configured to transfer heat generated in the battery module 100 to the lower plate 300 or to the outside. In one or more embodiments, as shown in FIG. 2, the heat dissipating member 600 may be on the lower plate 300 and may contact the lower holder 110. In one or more embodiments, the heat dissipating member 600 may be a thermally conductive adhesive. The heat dissipating member 600 may correspond to each lower holder 110 included in the battery module 100. The heat dissipating member 600 may be on the lower plate 300 to transfer heat generated in the battery cells C to the lower plate 300 for cooling, thereby dissipating the heat in the battery module 100.

FIGS. 10A and 10B illustrate a bending test on the circuit board 200. In one or more embodiments as shown in FIG. 10A, the circuit board 200 in which a plurality of second portions 220 are provided on the first portion 210 is prepared. To easily perform a bending test, the plurality of second portions 220 may be formed on only one of both side surfaces of the first portion 210. In one or more embodiments, as shown in FIG. 10A, the circuit board 200 in which five second portions 220a, 220b, 220c, 220d, and 220e are provided on the first portion 210 is prepared.

During the test, the plurality of second portions 220 are inserted into a bender B. As shown in FIG. 10B, the bender B may be configured so that a first surface and a second surface of the second portion 220 are inserted into the bender B. In one or more embodiments, as shown in (a) of FIG. 10B, the bender B may have a gap into which the second portion 220 is inserted. In a state in which the second portion 220 is inserted into the gap, the bender B may rotate in one direction. In one or more embodiments, as shown in (b) of FIG. 10B, the bender B may rotate by 90° counterclockwise with respect to the first portion 210. Again, in the opposite direction (e.g., the clockwise direction), the bender B may rotate by 90° with respect to the first portion 210.

Table 1 and Table 2 show whether an opening has occurred, whether a short-circuit has occurred, and the resistance values of the five second portions 220a, 220b, 220c, 220d, and 220e before and after the bending test. As shown in Table 1 and Table 2, an opening and a short-circuit have not occurred in the circuit both before and after the bending test, and there is little change in resistance values of the second portions 220 even after the bending test.

**Table 1**

| | Open | Short-circuit | A(Ω) | B(Ω) | C(Ω) | D(Ω) | E(Ω) |
|---|---|---|---|---|---|---|---|
| 1 | X | X | 1.053 | 1.089 | 1.147 | 1.105 | 1.120 |
| 2 | X | X | 1.145 | 1.080 | 1.113 | 1.021 | 1.122 |

**Table 2**

| | Open | Short-circuit | A(Ω) | B(Ω) | C(Ω) | D(Ω) | E(Ω) |
|---|---|---|---|---|---|---|---|
| 3 | X | X | 1.056 | 1.092 | 1.150 | 1.107 | 1.122 |
| 4 | X | X | 1.146 | 1.081 | 1.113 | 1.022 | 1.121 |

A battery pack according to embodiments may improve the durability and reliability of a circuit board.

However, technical effects of the disclosure are not limited thereto, and other unmentioned technical effects will be apparent to one of ordinary skill in the art from the following description.

## Claims

1. A battery pack (10) comprising:
a battery module (100) comprising a plurality of battery cells (C) and a bus bar (130) configured to electrically connect the plurality of battery cells (C); and
a circuit board (200) connected to the battery module (100),
wherein the circuit board (200) comprises:
a first portion (210) extending in a longitudinal direction of the battery module (100);
a plurality of second portions (220) extending from the first portion (210) in a direction crossing the first portion (210), each of the plurality of second portions (220) comprising a circuit pattern (221); and
a plurality of third portions (230) connected to ends of the plurality of second portions (220), the plurality of third portions (230) being connected to the bus bar (130),
wherein each second portion (220) of the plurality of second portions (220) extends straight without being bent or folded.

2. The battery pack (10) of claim 1, wherein each second portion (220) of the plurality of second portions (220) extends obliquely with respect to a longitudinal direction of the first portion (210).

3. The battery pack (10) of claim 1 or 2, wherein each second portion (220) of the plurality of second portions (220) comprises a base (224),
wherein the circuit pattern (221) is on the base (224), and
wherein the circuit pattern (221) comprises a curved portion.

4. The battery pack (10) of claim 3, wherein a first end of the circuit pattern (221) is connected to the first portion (210) and a second end of the circuit pattern (221) is connected to a third portion (230) of the plurality of third portions (230), and wherein the circuit pattern (221) comprises one or more convex portions (2211a, 2212a, 2213a) and/or one or more concave portions (2211b, 2212b, 2213b) between the first end and the second end.

5. The battery pack (10) of claim 3 or 4, wherein the circuit pattern (221) comprises a plurality of circuit patterns (221) having a wave shape, and
wherein a thickness (w) of each of the plurality of circuit patterns (221) is less than an interval between the plurality of circuit patterns (221).

6. The battery pack (10) of claim 5, wherein the thickness (w) of the circuit pattern (221) is from 0.2 mm to 0.5 mm.

7. The battery pack (10) of claim 5 or 6, wherein the plurality of circuit pattern (221) comprises:
a first pattern (2111, 2211) at a center in a width direction of the base (224); and
a second pattern (2212) adjacent to the first pattern (2111, 2211) and spaced apart from the first pattern (2111, 2211).

8. The battery pack (10) of claim 7, wherein the circuit pattern (221) further comprises a third pattern (2213) on the base (224), the third pattern (2213) being spaced apart from the first pattern (2111, 2211), and wherein the third pattern (2213) and the second pattern (2212) are on opposite sides of the first pattern (2111, 2211).

9. The battery pack (10) of any of claims 3 to 8, wherein each second portion (220) of the plurality of second portions (220) further comprises a dummy pattern (222) on the base (224), the dummy pattern (222) being spaced apart from the circuit pattern (221) and having a curved shape corresponding to the curved portion of the circuit pattern (221).

10. The battery pack (10) of claim 9, wherein the dummy pattern (222) comprises a pair of dummy pattern portions on both sides in a width direction of the base (224), and wherein the circuit pattern (221) is between the pair of dummy pattern portions.

11. The battery pack (10) of claim 9 or 10, wherein:
the first portion (210) comprises a first connection area (211) connected to the circuit pattern (221), and
each second portion (220) comprises a second connection area (223) connected to the circuit pattern (221) and the third portion (230), and
the dummy pattern (222) is spaced apart from each of the circuit pattern (221), the first connection area (210), and the second connection area (220).

12. The battery pack (10) of claim 1, wherein:
the second portion (220) extends at an interior angle θ with respect to a longitudinal direction of the first portion (210).

13. The battery pack (10) of claim 12, wherein:
the first portion (210) has a rod shape extending straight in a direction parallel to the longitudinal direction of the battery pack (10) and
the second portion (220) is inclined at the angle θ with respect to the longitudinal direction of the first portion (210) on both side surfaces of the first portion (210) and extends straight without being folded or bent.

14. The battery pack (10) of claim 11 or 12, wherein:
the angle θ is 30° to 80°.
